# FASCICULE DE BREVET EUROPEEN

(11) **EP 2 591 515 B1**
(45) Date de publication et mention de la délivrance du brevet: **08.04.2015**
(21) Numéro de dépôt: 11730951.8
(22) Date de dépôt: 05.07.2011
(51) Int. Cl.: H01L 41/313

(54) **PROCEDE D'IMPLANTATION D'UN MATERIAU PIEZOELECTRIQUE**
VERFAHREN ZUR IMPLANTIERUNG EINES PIEZOELEKTRISCHEN MATERIALS
METHOD FOR IMPLANTING A PIEZOELECTRIC MATERIAL

(30) Priorité: 06.07.2010 FR 1055478
(43) Date de publication de la demande: 15.05.2013
(73) Titulaire: Commissariat à l'Énergie Atomique et aux Énergies Alternatives, 75015 Paris (FR); Soitec, 38190 Bernin (FR)
(72) Inventeur: DEGUET, Chrystel, F-38330 Saint Ismier (FR); BLANC, Nicolas, F-26300 Bourg-de-Peage (FR); IMBERT, Bruno, F-38000 Grenoble (FR); MOULET, Jean-Sébastien, F-73000 Chambery (FR)
(74) Mandataire: Ilgart, Jean-Christophe
(86) Numéro de dépôt international: PCT/EP2011/061290
(87) Numéro de publication internationale: WO 2012/004250

(56) Documents cités:
- US-B2- 6 767 749
- PIJOLAT M ET AL: "Mode conversion in high overtone bulk acoustic wave resonators", 2009 JOINT MEETING OF THE EUROPEAN FREQUENCY AND TIME FORUM (EFTF'09) AND THE IEEE INTERNATIONAL FREQUENCY CONTROL SYMPOSIUM (FCS'09), 20-24 APRIL 2009, BESANCON, FRANCE, 2009, pages 290-294, XP031492385,

## Description

### DOMAINE TECHNIQUE ET ART ANTÉRIEUR

Le développement des télécommunications radiofréquences depuis une dizaine d'années se traduit par un encombrement des bandes de fréquence autorisées. Pour profiter des plages de fréquence disponibles, les systèmes doivent inclure un filtrage de bande, avec une bande de transition étroite. Seuls les filtres à résonateurs en technologie SAW (ondes acoustiques de surface) ou BAW (ondes acoustiques de volume), utilisant les propriétés piézoélectriques des matériaux, permettent de tenir ces spécifications avec de faibles pertes et un encombrement réduit. Aujourd'hui, les couches piézoélectriques utilisées pour ces filtres sont réalisées par dépôt (filtres BAW) ou à partir de substrats massifs (filtres SAW).

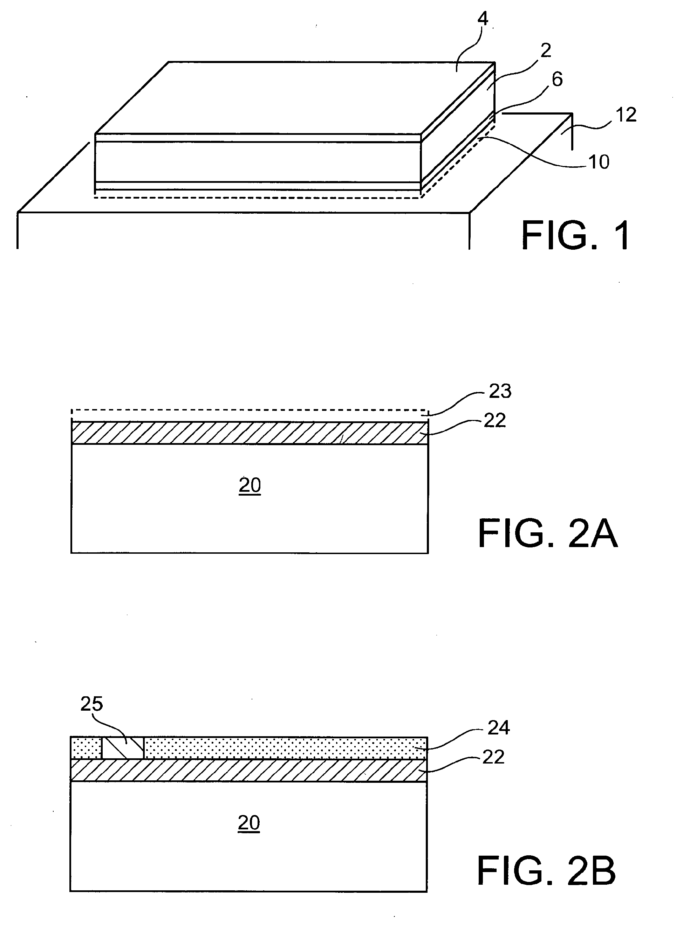

Un composant BAW est représenté schématiquement en figure 1 : il comporte une couche fine piézoélectrique 2 de l'ordre de 1µm d'épaisseur disposée entre deux électrodes 4, 6.

L'ensemble repose sur un substrat 12, mais en est éventuellement isolé acoustiquement par des moyens 10. L'isolation acoustique peut être obtenue soit en suspendant le film piézoélectrique au dessus d'une cavité (technologie FBAR), soit en le séparant du substrat par un réseau de Bragg (technologie SMR).

Les couches de matériaux piézoélectriques pour ce type de dispositif sont en général réalisées par des techniques de dépôts de type PVD. On élabore ainsi des couches dans une gamme d'épaisseur comprise entre quelques centaines de nm et le µm.

Outre les techniques de dépôt, des techniques de report après implantation ont fait l'objet de divers travaux.

Le document intitulé «fabrication of single-crystal lithium niobate films by crystal ion slicing », de M. Levy et al., Applied Physics Letters, vol 73, nb 16 (1998) 2293 décrit un exemple d'implantation à haute énergie (3,8 MeV) pour une dose de 5x10¹⁶ He⁺ ions/cm², permettant de réaliser le transfert d'une couche épaisse de LiNbO₃ de l'ordre de 9 µm. Cependant, de par les énergies d'implantation utilisées, de plusieurs MeV, cette technique est difficilement industrialisable et le transfert de film mince (inférieur au micromètre) n'a pas été démontré.

Une autre étude, intitulée "Integration of single-crystal LiNbO3 thin film on silicon by laser irradiation and ion implantation-induced layer transfer", par Y.B. Park et al., Advanced Materials, vol 18 (2006) 1533, décrit d'autres conditions en terme d'implantation. Ce document montre le transfert de 800 nm de LiNbO3 par co-implantation d'ions H⁺ à 80 keV avec une dose de 5x10¹⁶ ions/cm² et d'hélium à 115 keV avec une dose de 10¹⁷ ions/cm². Dans ce document, le transfert est réalisé à l'aide d'un laser cw-CO₂ (de densité de puissance 100 MW.m⁻²) utilisé comme source de chaleur.

Le document US 2010/0088868A1 et l'article de Q.Wan et al. intitulé "Investigation of H+ and B+/H+ implantation in LiTaO3 single crystals", Nuclear Instruments and Methods in Physics Research », B 184 (2001) p.53 décrivent également la formation de couches à base de LiTaO₃ et LiNbO₃ par report.

Les techniques connues de US 6,767,7492 permet de reporter un empilement élémentaire comportant une couche piézoélectrique et une couche métallique enterrée.

La formation d'un tel empilement élémentaire serait cependant nécessaire en vue de réaliser d'autres composants à base de matériau piézoélectrique, par exemple des filtres tels que ceux présentés ci-dessus, mais encore éventuellement d'autres types de composants.

### EXPOSÉ DE L'INVENTION

L'invention propose d'abord un procédé de réalisation d'une structure à base d'un matériau piézoélectrique, comportant :
a) la réalisation d'un empilement comportant au moins une couche métallique et/ou au moins une couche superficielle conductrice du point de vue électrique sur un substrat en matériau piézoélectrique, par exemple en LiNbO₃ ou en LiTaO₃, au moins un contact électrique étant établi entre la couche conductrice et un élément métallique extérieur à l'empilement,
b) une implantation d'une ou plusieurs espèces gazeuses, à travers au moins ladite couche conductrice et la couche métallique, pour former une zone de fragilisation dans le substrat piézoélectrique,
c) un assemblage de l'empilement ainsi obtenu sur un substrat de report puis une fracture du substrat piézoélectrique, au niveau de la zone de fragilisation, pour former un ensemble comportant au moins une couche en matériau piézoélectrique, une couche métallique et le substrat de report.

Ainsi l'invention propose un procédé permettant de réaliser un substrat présentant une électrode enterrée (qui peut être constituée par la couche métallique) et une couche piézoélectrique en surface, obtenue par exemple à partir d'un substrat massif de matériau piézoélectrique, par exemple de type LiNbO₃ ou LiTaO₃.

Avantageusement, la couche conductrice d'un point de vue électrique est également conductrice d'un point de vue thermique.

L'implantation, de préférence à une énergie inférieure à 500 keV, est réalisée à travers une couche métallique enterrée sous au moins une couche conductrice superficielle. Sans cette couche conductrice superficielle sur le trajet du faisceau d'implantation, les inventeurs ont observé que la fracture ne pouvait pas être obtenue ou même que les plaques obtenues cassaient pendant l'implantation.

Parmi les métaux utilisables en tant que couche conductrice superficielle on trouve notamment les métaux de transition (dont Mo, ou Ni, ou Pt, ou Cr, ou Ru, ou Ti, ou W, ou Co, Ta, Cu) ou pauvres (dont Al, ou Sn, ou Ga...) et leurs alliages. On trouve également AlSi ou encore AlCu. De préférence le métal utilisé présente une conductivité thermique et électrique supérieure à, respectivement, 10W/m.K et 10⁶ Siemens/m (pour le Ti : 21 W/m.K et 2.4x10⁶ S/m)

En ce qui concerne le métal utilisable pour l'électrode enterrée : aux paramètres précédents on peut ajouter la compatibilité acoustique (impédance acoustique supérieure 1.10⁵ g/cm².s ; pour Al celle-ci est à 13.8x10⁵ g/cm².s) à la liste déjà citée (en particulier si l'application visée est celle d'un filtre RF).

Elle a de préférence une résistivité électrique carrée inférieure à 10 Ω ou encore à 1 Ω.

L'une et/ou l'autre de la couche métallique et de la couche conductrice peut avoir une épaisseur comprise entre 10 nm et 200 nm.

Un procédé selon l'invention peut comporter en outre, avant l'étape b), une étape de densification des matériaux de l'empilement.

Dans un mode de réalisation, la couche métallique et la couche conductrice superficielle forment une seule et même couche.

On peut alors, après l'étape d'implantation et avant l'étape de collage, éliminer une partie de l'épaisseur de la couche métallique.

Dans un autre mode de réalisation, la couche métallique enterrée et la couche conductrice superficielle forment des couches distinctes. On peut, alors, éliminer la couche conductrice superficielle après l'étape b) d'implantation et avant l'étape c) d'assemblage. Le procédé peut, dans ce cas, comporter en outre la formation d'une couche de collage ou d'une couche sacrificielle, ou d'un réseau de Bragg, sur ladite couche métallique.

Au moins une couche de collage peut être formée sur le substrat en matériau piézoélectrique et/ou le substrat de report pour faciliter l'assemblage. En variante, la couche métallique peut être préparée pour remplir cette fonction.

Avantageusement, un contact électrique peut être établi entre la couche métallique et soit la couche conductrice, soit un élément métallique extérieur à l'empilement. Cet élément métallique extérieur peut faire partie du dispositif d'implantation, ce peut être un substrat support du dispositif d'implantation sur lequel l'empilement est positionné en vue de l'implantation.

### BRÈVE DESCRIPTION DES DESSINS

- La figure 1 représente un composant de type BAW ;
- les figures 2A à 2E représentent des étapes de préparation d'un premier substrat, selon un procédé selon l'invention ;
- la figure 3 représente la préparation d'un substrat de report ;
- les figures 4A et 4B représentent des étapes de transfert, sur un substrat de report, d'une couche en matériau piézoélectrique avec électrode enterrée.

### EXPOSÉ DÉTAILLÉ DE MODES DE RÉALISATION DE L'INVENTION

Un procédé selon l'invention met en oeuvre un substrat en un matériau piézoélectrique.

Dans ce document, on fait mention à plusieurs reprises d'un procédé de report de film mince basé par une technique d'implantation et de fracture. Un tel procédé est décrit par exemple dans le brevet FR 2681472 ou l'article de B. Aspar et A.J. Auberton-Hervé « Silicon Wafer Bonding Technology for VLSI and MEMS applications », edited by S.S. Iyer and A.J. Auberton-Hervé, 2002, INSPEC, London, Chapter 3, pages 35-52.

Dans la suite, il est également fait référence au collage moléculaire encore appelé collage direct. Cette technique d'assemblage est décrite notamment par Q.Y. Tong dans « Silicon Wafer Bonding Technology for VLSI and MEMS applications », Edited by S.S. Iyer et A.J. Auberton-Hervé, 2002, INSPEC, London, Chapter 1, pages 1 - 20.

Le matériau piézoélectrique dont il est question ci-dessous est par exemple choisi parmi la Berlinite (AlPO₄), l'oxyde de Zinc (ZnO), le Quartz, le Topaze, l'orthophosphate de Gallium (cristal GaPO₄), le Langasite (La₃Ga₅SiO₁₄), le titanate de Barium (cristal BaTiO₃), ou le titanate de Plomb (PbTiO₃), ou le zirconate titanate de Plomb (Pb(ZrTi)O₃) (PZT), ou le niobate de Potassium (KNbO₃), ou le niobate de Lithium (LiNbO₃), ou le tantalate de Lithium (LiTaO₃), ou le tungstate de Sodium (NaxWO₃), ou le Ba₂NaNb₅O₅, ou le Pb₂KNb₅O₁₅.

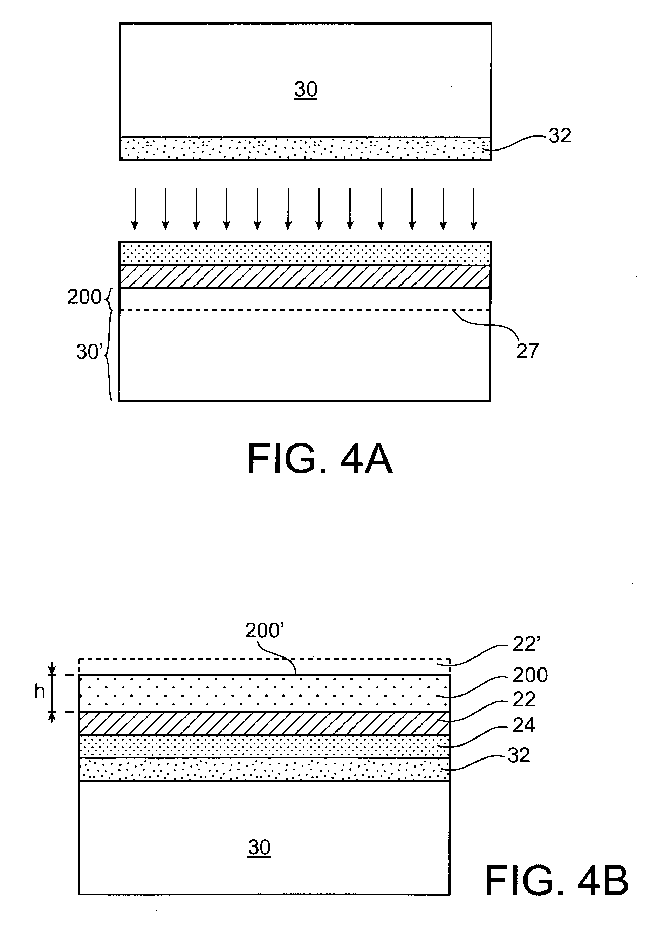

Un exemple de dispositif selon l'invention, ou obtenu par un procédé selon l'invention, est illustré en figure 4B.

Dans cette structure, une couche fine 200 de matériau piézoélectrique repose sur une électrode métallique enterrée 22. L'ensemble repose lui-même sur un substrat hôte 30. Une zone de collage, comportant éventuellement une ou plusieurs couches de collage 24, 32, relie le substrat 30 et la couche d'électrode métallique 22. En variante, l'électrode métallique est directement assemblée sur le substrat 30.

En d'autres termes, cet empilement comporte, dans cet ordre :
- le substrat 30,
- éventuellement, une ou plusieurs couches de collage,
- l'électrode 22,
- et enfin la couche piézoélectrique 200, en un matériau tel que l'un de ceux indiqués ci dessus.

D'autres couches non représentées (par exemple formant miroir de Bragg ou couche sacrificielle...) peuvent être prévues entre le substrat 30 et l'électrode 22.

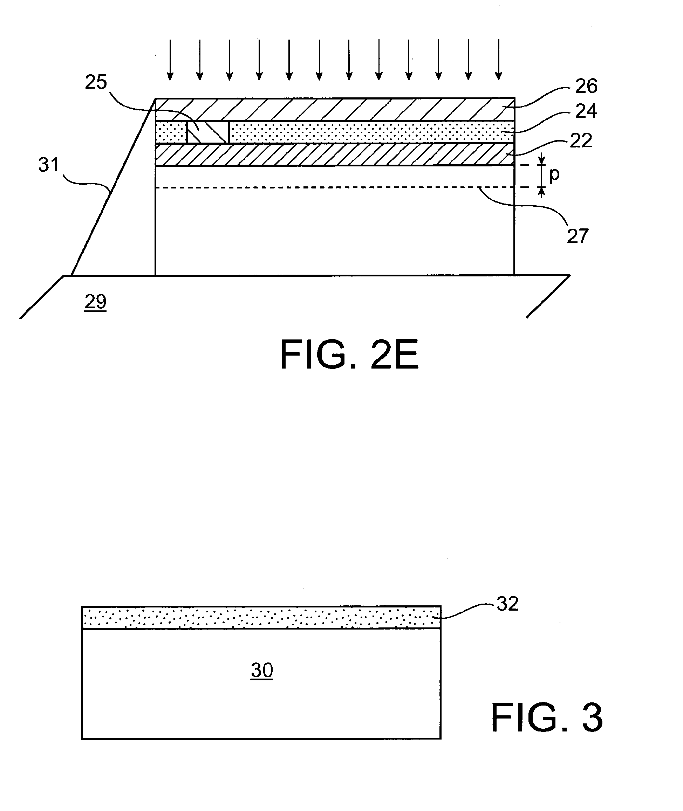

Une mise en oeuvre d'un procédé selon l'invention va maintenant être décrite, en liaison avec les figures 2A-2E.

Il s'agit ici de la réalisation d'un substrat du type de celui de la figure 4B, dans lequel la couche 200 de matériau piézoélectrique, par exemple en LiNbO₃, a été transférée sur une base quelconque 30 avec une électrode métallique enterrée.

Un substrat 20 piézoélectrique (par exemple de type LiNbO₃, ou LiTaO₃ ...) massif est choisi. Le matériau et notamment son orientation cristalline sera choisi en fonction de l'application visée.

Une couche métallique 22 est formée sur une face de ce substrat 20 (figure 2A).

Cette couche 22 peut être une simple couche métallique, qui formera une électrode enterrée. En variante, au moins une couche supplémentaire 23 (en pointillés sur la figure 2A) est également formée sur cette couche 22. Cette couche supplémentaire peut être par exemple une couche sacrificielle ou bien un réseau de Bragg (pouvant comporter une alternance de couches de W/SiO₂) dont le rôle comme décrit précédemment, sera à terme (après élimination localisée de le couche sacrificielle notamment) d'isoler acoustiquement la couche piézoélectrique du substrat.

Le métal de la couche métallique 22 peut être par exemple choisi parmi l'un des métaux suivants : Cu, AlCu, AlSi, W, Mo, Pt, Cr .... D'autres exemples de matériaux et de critères de sélection ont déjà été donnés ci-dessus (conductivité thermique et/ou électrique supérieure à, respectivement, 10W/m. K et/ou 10⁶ Siemens/m et/ou ayant une impédance acoustique supérieure 1.10⁵ g/cm².s).

L'ensemble de l'empilement constitué par le substrat 20 et la couche 22 (et l'éventuelle couche 23 supplémentaire) est ensuite, dans cet exemple, recouvert avec une couche 24, dite de collage (figure 2B). Elle peut être en un matériau isolant électriquement et/ou thermiquement. C'est par exemple une couche de dioxyde de silicium (SiO₂), de quelques centaines de nm d'épaisseur, par exemple comprise entre 10 nm et 500 nm, par exemple encore égale à environ 200 nm. En variante, le rôle de couche de collage peut être rempli directement par la couche métallique 22 destinée à former l'électrode.

Eventuellement, une zone 25 conductrice peut être réalisée dans la couche de collage 24, par exemple par gravure de cette couche 24 puis dépôt du matériau conducteur approprié. La fonction de cette zone 25 sera expliquée plus loin.

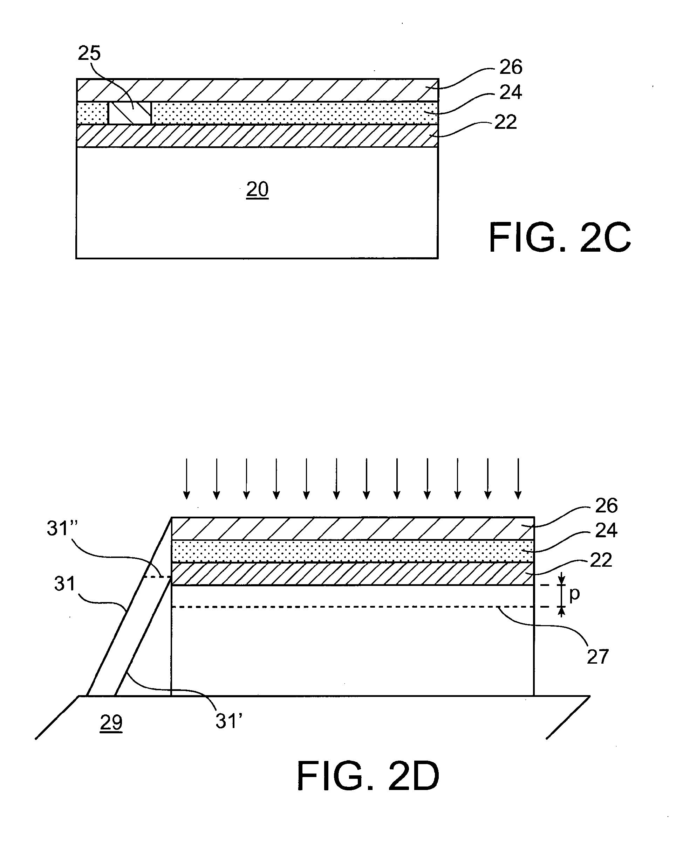

Une couche 26 au moins électriquement conductrice, est ensuite déposée (figure 2C) sur la couche 24 de collage. Cette couche est avantageusement également thermiquement conductrice. Il peut s'agir par exemple d'une couche en Mo, ou Ti, ou Al, ou AlSi, ou AlCu, ou W. Ses propriétés de conduction électrique lui confèrent une résistivité carrée inférieure à environ 10 Ω. Avantageusement on prendra une résistance carrée inférieure à environ 1 Ω ou de l'ordre de 0,5 Ω. Ainsi si l'on prend un matériau de résistivité 5 µΩ.cm, une épaisseur de 100 nm conviendra pur cette couche. Plus généralement, cette couche a de préférence une épaisseur comprise entre environ 10 nm et 200 nm. La conductivité thermique de cette couche, est avantageusement supérieure à 10 W/m.K, préférentiellement voisine de 50 W/m.K.

En variante, le rôle de couche superficielle conductrice peut être rempli directement par la couche métallique 22 destinée à former l'électrode, notamment si celle-ci présente les propriétés de conductions requises précédemment définies pour la couche conductrice. Elle n'est alors recouverte d'aucune couche supplémentaire et joue donc également le rôle de couche de collage.

L'empilement réalisé peut être densifié, avant ou après le dépôt de cette couche conductrice 26, selon la nature des matériaux déposés, par exemple par traitement thermique à une température comprise entre 300°C et 600°C pendant quelques heures.

Cet empilement est amené en contact avec le substrat support 29, en général en aluminium, d'un dispositif d'implantation (figure 2D) : au moins un contact 31 est établi entre la couche conductrice 26 et la surface de ce substrat support 29 ou tout autre élément pouvant servir de référence de masse électrique.

Ce contact 31 peut être établi par le biais d'un bras au moins partiellement électriquement conducteur qui sert également pour le maintien mécanique de l'empilement sur le substrat support 29. Dans ce cas, le contact pourra être établi avec une légère pression mécanique du bras sur l'empilement permettant ainsi également de maintenir l'empilement vertical pendant l'étape d'implantation.

Un autre contact 31' peut être établi entre la couche d'électrode 22 et le support 29. En variante, un contact 31" peut être établi entre cette couche 22 et le contact 31 (il est représenté sur la figure 2D en traits interrompus).

Ce ou ces contacts permet(tent) d'assurer une conductivité électrique entre la couche 22 et/ou la couche 26 et un élément extérieur à l'empilement servant de référence de masse électrique.

Selon encore une autre variante, le contact électrique entre la couche d'électrode 22 et la couche conductrice 26 peut être obtenu par le biais d'une zone conductrice 25 réalisée dans la couche de collage dès l'étape déjà décrite en liaison avec la figure 2B.. On procède ensuite à une implantation d'une ou plusieurs espèces gazeuses, de préférence au moins de l'hélium dans le cas du LiNbO₃, à une profondeur moyenne p proche de l'épaisseur souhaitée pour la couche mince 200 de matériau piézoélectrique à reporter (figure 2D). Est ainsi formée une zone 27 de fragilisation. La profondeur d'implantation peut être quelconque, en fonction de l'énergie du faisceau d'implantation.

Par exemple l'implantation réalisée est à base d'hélium ou d'hydrogène ou d'un mélange d'hydrogène et d'hélium, avec des doses comprises entre 10¹⁶ at/cm² et 10¹⁷ at/cm², et avec une énergie comprise entre 50 keV et 240 keV selon l'épaisseur à transférer.

Après cette implantation, la couche conductrice 26 est retirée, par exemple par une technique de gravure chimique, ou par gravure sèche ou par polissage. Avantageusement, on choisira une technique de gravure sélective pour graver la couche conductrice sans graver la couche sous-jacente (la couche de collage 24 ou la couche métallique 22 selon les cas).

Si la couche métallique 22 fait office de couche conductrice superficielle 26, elle peut être partiellement gravée sur une partie de son épaisseur afin d'éliminer la partie superficielle qui aurait pu être endommagée par l'étape d'implantation.

Par ailleurs, on prépare un second substrat 30 (qui peut être piézoélectrique par exemple en LiNbO₃ ou autre, par exemple en Silicium ou en Saphir ou en Quartz ...), sur une surface duquel on dépose éventuellement des couches d'intérêt (couches formant miroir de Bragg ou couche sacrificielle par exemple) et éventuellement une couche 32 de collage, de préférence une couche diélectrique, par exemple en SiO₂ (figure 3). Là encore, cette couche de collage peut avoir une épaisseur comprise entre 10 nm et 500 nm, elle est de préférence voisine de 200 nm.

Les 2 substrats ainsi préparés peuvent ensuite subir un traitement spécifique en vue d'un collage: les surfaces destinées à être mises en contact puis assemblées subissent par exemple un polissage mécano chimique (type CMP). Ce traitement permet notamment d'obtenir la rugosité souhaitée pour le collage ainsi que l'activation de surface adéquate.

Les deux substrats sont ensuite collés par collage direct (figure 4A). Les couches de collage 24, 32 et/ou les faces ayant subi un traitement spécifique en vue d'un collage sont amenées en contact l'une de l'autre.

Par traitement thermique éventuellement assisté de l'application d'un effort mécanique, on initie le transfert du film mince 200 piézolélectrique, par fracture le long de la zone de fragilisation 27 (figure 4B). Par exemple, un traitement thermique est réalisé entre 100°C et 500°C, préférentiellement vers 250°C, afin d'initier le transfert du film mince 200. Ce traitement thermique permet de faire mûrir les microcavités formées lors de l'étape d'implantation dans la zone 27, ce qui entraîne la fracture désirée. La présence de la couche conductrice pendant l'étape d'implantation permet d'obtenir ce transfert sans casse de l'empilement.

Un procédé de finition de la surface de la couche ou du film 200 (tel qu'un traitement thermique et/ou un polissage pour obtenir une rugosité compatible avec la réalisation ultérieure de composants en surface de cette couche 200) peut être effectué.

On obtient ainsi une couche fine 200 de matériau piézoélectrique avec électrode métallique enterrée 22 sur un substrat hôte 30. Une zone de collage définie par les couches 24, 32 relie éventuellement le substrat 30 et la couche d'électrode métallique 22. Comme déjà mentionné, d'autres couches peuvent également être prévues entre la couche d'électrode et le substrat hôte. En d'autres termes, on obtient un empilement comportant au moins le substrat 30, sur lequel est formée une zone de collage, constituée par les deux couches 24, 32, sur lesquels est disposée l'électrode 22, sur laquelle est disposée la couche piézoélectrique 200.

En particulier, on peut réaliser sur la surface 200' de la couche 200 une deuxième électrode 22' (en pointillés sur la figure 4B).

Par ailleurs, la portion 30' du substrat 20 qui a été enlevée à la suite de la fracture peut être réutilisée pour former une autre couche de matériau piézoélectrique.

## Revendications

1. Procédé de réalisation d'une structure à base d'un matériau piézoélectrique, comportant :
a) la réalisation d'un empilement comportant soit au moins une couche métallique enterrée (22) et au moins une couche électriquement conductrice superficielle (26), soit au moins une couche métallique superficielle (22, 26), sur un substrat en matériau piézoélectrique (20), au moins un contact électrique (31) étant établi entre soit la couche conductrice superficielle (26) soit la couche métallique superficielle (22, 26), et un élément métallique (29) extérieur à l'empilement,
b) l'implantation d'une ou plusieurs espèces gazeuses, à travers au moins soit ladite couche conductrice superficielle et la couche métallique enterrée (22), soit la couche métallique superficielle (22, 26), pour former une zone de fragilisation (27) dans le substrat piézoélectrique,
c) l'assemblage de l'empilement formé sur un substrat de report (30) puis la fracture de ce substrat piézoélectrique, au niveau de la zone de fragilisation (27), pour former un empilement comportant au moins une couche (200) en matériau piézoélectrique, une couche métallique (22) et le substrat de report (30).

2. Procédé selon la revendication 1, soit ladite couche (26) conductrice superficielle soit ladite couche métallique superficielle (22, 26) étant également conductrice du point de vue thermique.

3. Procédé selon l'une des revendications précédentes, soit ladite couche (26) conductrice superficielle soit ladite couche métallique superficielle (22, 26) étant en un matériau choisi parmi les métaux de transition, par exemple parmi les matériaux suivants : Mo, Ni, Pt, Cr, Ru, Ti, W, Co, Ta, Cu, ou pauvres, par exemple parmi Al, Sn, Ga, et leurs alliages et/ou présentant une conductivité thermique et/ou électrique supérieure à, respectivement, 10W/m. K et/ou 10⁶ Siemens/m et/ou ayant une impédance acoustique supérieure 1.10⁵ g/cm².s.

4. Procédé selon l'une des revendications précédentes, soit ladite couche (26) conductrice superficielle soit ladite couche métallique superficielle (22, 26) ayant une résistivité carrée inférieure à 10 Ω.

5. Procédé selon l'une des revendications précédentes, soit ladite couche (26) conductrice superficielle soit ladite couche métallique superficielle (22, 26) ayant une résistivité carrée inférieure à 1 Ω.

6. Procédé selon l'une des revendications précédentes, soit ladite couche (26) conductrice superficielle soit ladite couche métallique superficielle (22, 26) ayant une épaisseur comprise entre 10 nm et 200 nm.

7. Procédé selon l'une des revendications précédentes, comportant en outre, avant l'étape b), une étape de densification des matériaux de l'empilement.

8. Procédé selon l'une des revendications précédentes, dans lequel on réalise, lors de l'étape a), au moins une couche métallique superficielle (22,26), et on élimine, après l'étape d'implantation et avant l'étape de collage, une partie de l'épaisseur de cette couche métallique.

9. Procédé selon l'une des revendications 1 à 7, dans lequel on réalise, lors de l'étape a), au moins une couche métallique enterrée (22) et au moins une couche électriquement conductrice superficielle (26), cette couche métallique enterrée (22) et la couche conductrice superficielle (26) formant des couches distinctes.

10. Procédé selon la revendication 9, dans lequel on élimine la couche conductrice superficielle après l'implantation après l'étape b) d'implantation et avant l'étape c) d'assemblage.

11. Procédé selon l'une des revendications 9 ou 10, comportant en outre la formation d'une couche de collage (24) ou d'une couche sacrificielle (23), ou d'un réseau de Bragg, sur ladite couche métallique (22).

12. Procédé selon l'une des revendications 9 à 11, comportant en outre l'établissement de contact électrique (31', 31'', 25) entre la couche métallique (22) et soit la couche conductrice (26), soit un élément métallique (29) extérieur à l'empilement.

13. Procédé selon l'une des revendications 1 à 12, l'élément métallique (29) extérieur à l'empilement étant un substrat support du dispositif d'implantation.

14. Procédé selon l'une quelconque des revendications précédentes, comportant en outre une étape de formation d'une couche sacrificielle, ou d'un réseau de Bragg, ou d'une couche de collage (32), sur le substrat de report avant l'assemblage.

15. Procédé selon l'une quelconque des revendications précédentes, le matériau piézoélectrique étant en LiNbO₃ ou en LiTaO₃.

## Patentansprüche

1. Verfahren zum Ausführen einer Struktur auf der Grundlage eines piezoelektrischen Materials, das Folgendes umfasst:
a) das Ausführen eines Stapels, der entweder mindestens eine vergrabene metallische Schicht (22) und mindestens eine elektrisch leitfähige Oberflächenschicht (26) oder mindestens eine metallische Oberflächenschicht (22, 26) auf einem Substrat aus piezoelektrischem Material (20) umfasst, wobei mindestens ein elektrischer Kontakt (31) zwischen entweder der leitfähigen Oberflächenschicht (26) oder der metallischen Oberflächenschicht (22, 26) und einem metallischen Element (29) außerhalb des Stapels hergestellt wird,
b) die Implantation von einer oder mehreren Gasarten durch mindestens entweder die leitfähige Oberflächenschicht und die vergrabene metallische Schicht (22) oder die metallische Oberflächenschicht (22, 26) zum Bilden einer Versprödungszone (27) in dem piezoelektrischen Substrat,
c) das Zusammenbauen des gebildeten Stapels auf einem Transfersubstrat (30), dann das Brechen dieses piezoelektrischen Substrats im Bereich der der Versprödungszone (27) zum Bilden eines Stapels, der mindestens eine Schicht (200) aus piezoelektrischem Material, eine metallische Schicht (22) und das Transfersubstrat (30) umfasst.

2. Verfahren nach Anspruch 1, wobei entweder die leitfähige Oberflächenschicht (26) oder die metallische Oberflächenschicht (22, 26) auch in thermischer Hinsicht leitfähig ist.

3. Verfahren nach einem der vorhergehenden Ansprüche, wobei entweder die leitfähige Oberflächenschicht (26) oder die metallische Oberflächenschicht (22, 26) aus einem Material ist, das unter Übergangsmetallen, zum Beispiel den folgenden Materialien gewählt wird: Mo, Ni, Pt, Cr, Ru, Ti, W, Co, Ta, Cu oder armen, zum Beispiel unter Al, Sn, Ga und ihren Legierungen und/oder die eine thermische und/oder elektrische Leitfähigkeit aufweisen, die höher ist als 10W/m.K beziehungsweise 10⁶ Siemens/m und/oder eine akustische Impedanz aufweisen, die höher ist als 1.10⁵ g/cm².s.

4. Verfahren nach einem der vorhergehenden Ansprüche, wobei entweder die leitfähige Oberflächenschicht (26) oder die metallische Oberflächenschicht (22, 26) eine Volumenresistivität aufweist, die kleiner ist als 10 Ω.

5. Verfahren nach einem der vorhergehenden Ansprüche, wobei entweder die leitfähige Oberflächenschicht (26) oder die metallische Oberflächenschicht (22, 26) eine Volumenresistivität aufweist, die kleiner ist als 1 Ω.

6. Verfahren nach einem der vorhergehenden Ansprüche, wobei entweder die leitfähige Oberflächenschicht (26) oder die metallische Oberflächenschicht (22, 26) eine Dicke aufweist, die zwischen 10 nm und 200 nm enthalten ist.

7. Verfahren nach einem der vorhergehenden Ansprüche, das ferner vor dem Schritt b) einen Schritt zur Verdichtung der Materialien des Stapels umfasst.

8. Verfahren nach einem der vorhergehenden Ansprüche, wobei beim Schritt a) mindestens eine metallische Oberflächenschicht (22, 26) ausgeführt wird und nach dem Schritt der Implantation und vor dem Schritt des Klebens ein Teil der Dicke dieser metallischen Schicht beseitigt wird.

9. Verfahren nach einem der Ansprüche 1 bis 7, wobei beim Schritt a) mindestens eine vergrabene metallische Schicht (22) und mindestens eine elektrisch leitfähige Oberflächenschicht (26) ausgeführt werden, wobei diese vergrabene metallische Schicht (22) und die leitfähige Oberflächenschicht (26) getrennte Schichten bilden.

10. Verfahren nach Anspruch 9, wobei nach der Implantation nach dem Schritt b) zur Implantation und vor dem Schritt c) zum Zusammenbau die elektrisch leitfähige Oberflächenschicht beseitigt wird.

11. Verfahren nach einem der Ansprüche 9 oder 10, das ferner das Bilden einer Klebeschicht (24) oder einer Opferschicht (23) oder eines Bragg-Gitters auf der metallischen Schicht (22) umfasst.

12. Verfahren nach einem der Ansprüche 9 bis 11, das ferner das Herstellen eines elektrischen Kontakts (31', 31", 25) zwischen der metallischen Schicht (22) und entweder der leitfähigen Schicht (26) oder einem metallischen Element (29) außerhalb des Stapels umfasst.

13. Verfahren nach einem der Ansprüche 1 bis 12, wobei das metallische Element (29) außerhalb des Stapels ein Trägersubstrat der Implantationsvorrichtung ist.

14. Verfahren nach einem der vorhergehenden Ansprüche, das ferner einen Schritt zum Bilden einer Opferschicht oder eines Bragg-Gitters oder einer Klebeschicht (32) auf dem Transfersubstrat vor dem Zusammenbau umfasst.

15. Verfahren nach einem der vorhergehenden Ansprüche, wobei das piezoelektrische Material aus LiNbO₂ oder aus LiTaO₃ ist.

## Claims

1. Method of production of a structure made of a piezoelectric material, including:
a) production of a stack including either at least one buried metal layer (22) and at least one electrically conductive surface layer (26), or at least one metal surface layer (22, 26), on a substrate made of piezoelectric material (20), where at least one electrical contact (31) is established between either the conductive surface layer (26) or the at least one metal surface layer (22, 26), and a metal element (29) outside the stack,
b) implantation of one or more gaseous species, through at least either said electrically conductive surface layer and the buried metal layer (22), or the metal surface layer (22, 26), to form an embrittlement area (27) in the piezoelectric substrate,
c) assembly of the stack thus formed with a transfer substrate (30), followed by fracturing of this piezoelectric substrate, in the embrittlement area (27), to form a stack including at least one layer (200) made of piezoelectric material, a metal layer (22) and the transfer substrate (30).

2. A method according to claim 1, wherein either the said electrically conductive surface layer (26) or said metal surface layer (22, 26) is also conductive from the thermal standpoint.

3. A method according to one of the previous claims, wherein either the said conductive layer (26) or said metal surface layer (22, 26) is made of a material chosen from among the transition metals, for example from among the following materials: Mo, Ni, Pt, Cr, Ru, Ti, W, Co, Ta, Cu, or poor metals, for example from among Al, Sn, Ga, and their alloys, and/or having thermal and/or electrical conductivity greater than, respectively, 10W/m.K and/or 10⁶ Siemens/m, and/or having an acoustic impedance greater than 1.10⁵ g/cm².s.

4. A method according to one of the previous claims, wherein either the said conductive surface layer (26) or said metal surface layer (22, 26) has a squared resistivity of lower than 10 Ω.

5. A method according to one of the previous claims, wherein either the said conductive surface layer (26) or the said metal surface layer (22, 26) has a squared resistivity of lower than 1 Ω.

6. A method according to one of the previous claims, wherein either the said conductive surface layer (26) or the said metal surface layer (22, 26) is between 10 nm and 200 nm thick.

7. A method according to one of the previous claims, comprising, before step b), a step of densification of the materials of the stack.

8. A method according to claim 8, in which, during step a), at least one metal surface layer (22, 26) is formed and, after the step of implantation and before the step of bonding, a part of the thickness of said metal layer is eliminated.

9. A method according to one of the claims 1 to 7, wherein, during step a), at least one buried metal layer (22) and at least one electrically conductive surface layer (26) is formed, said buried metal layer (22) and said surface conductive layer (26) forming separate layers.

10. A method according to claim 9, in which the conductive surface layer is eliminated after implantation after step b) of implantation and before step c) of assembly.

11. A method according to one of the claims 9 or 10, comprising the formation of a bonding layer (24) or sacrificial layer (23), or of a Bragg network, on the said metal layer (22).

12. A method according to one of the claims 9 to 11, further comprising the establishment of an electrical contact (31', 31'', 25) between the metal layer (22) and either the conductive layer (26), or a metal element (29) outside the stack.

13. A method according to one of the claims 1 to 12, wherein the metal element (29) outside the stack is a substrate supporting the implantation device.

14. A method according to any one of the previous claims, comprising a step of formation of a sacrificial layer, or of a Bragg network, or of a bonding layer (32), on the transfer substrate before assembly.

15. A method according to any of the previous claims, wherein the piezoelectric material is made of LiNbO₃ or LiTaO₃.
